# DEMANDE DE BREVET EUROPEEN

(11) **EP 1 094 510 A1**
(43) Date de publication de la demande: **25.04.2001**
(21) Numéro de dépôt: 00410124.2
(22) Date de dépôt: 18.10.2000
(51) Int. Cl.: H01L 21/336, H01L 21/28, H01L 29/788

(54) **Procédé de fabrication de points mémoire eeprom**

(30) Priorité: 21.10.1999 FR 9913378
(71) Demandeur: STMicroelectronics S.A., 94250 Gentilly (FR)
(72) Inventeur: Ventajol, Philippe, 13090 Aix en Provence (FR)
(74) Mandataire: de Beaumont, Michel

(57) **Abrégé**

L'invention concerne un procédé de formation de points mémoire comportant des grilles de commande et flottante comprenant les étapes suivantes : délimiter à la surface d'un substrat semiconducteur (1) une région active par des zones d'isolement (2) ; former une première couche isolante (3) ; ouvrir une fenêtre dans la première couche isolante pour découvrir partiellement toute la largeur de la région active et une partie des zones d'isolement ; former une deuxième couche isolante très mince (4) ; déposer un premier conducteur (5) ; former une troisième couche isolante (6) ; et déposer un deuxième conducteur (7), et comprenant en outre une étape de gravure des premier et deuxième conducteurs et des troisième, deuxième et première couches isolantes selon un même contour pour découvrir la région active et les zones d'isolement au voisinage des frontières (OP1, OP2) entre la région active et les zones d'isolement.

## Description

La présente invention concerne, de façon générale, la fabrication de points mémoire de type EEPROM comportant, dans une partie d'une grille flottante, un isolant de grille de type tunnel.

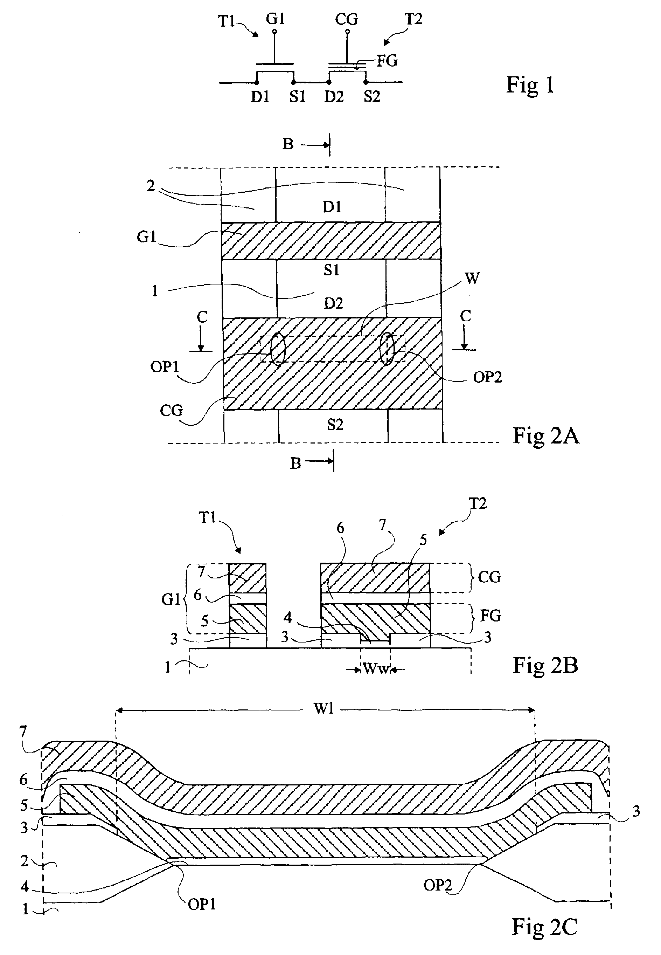

Des mémoires EEPROM sont formées à partir de cellules mémoire constituées, par exemple, comme l'illustre la figure 1, d'un transistor de lecture T1 et d'un point mémoire T2. Le transistor T1 est un transistor MOS classique comportant un drain D1, une source S1 et une grille isolée G1. Le point mémoire T2 est de type à double grille. Il comporte un drain D2, une source S2 et deux grilles isolées, à savoir une grille flottante FG et une grille de commande CG. On considérera ici le cas de points mémoire dont l'isolant de grille flottante comporte au moins une partie suffisamment mince pour permettre un passage par effet tunnel des porteurs entre le canal sous-jacent et la grille flottante, cet isolant étant appelé "isolant tunnel" ou "oxyde tunnel". La source S1 du transistor T1 est interconnectée au drain D2 du point mémoire T2.

Les figures 2A, 2B et 2C illustrent, respectivement une vue de dessus et des vues en coupe selon des axes respectifs B-B et C-C, d'une cellule mémoire classique.

La cellule est formée dans une région active d'un substrat semiconducteur 1, typiquement en silicium monocristallin, délimitée latéralement par des zones d'isolement de champ 2.

Une couche isolante 3 est destinée à constituer l'isolant de grille du transistor T1 et la partie non-tunnel de l'isolant de la grille flottante FG du point mémoire T2. L'isolant 3 est généralement une couche d'oxyde de silicium (SiO₂) déposée par voie chimique en phase vapeur.

La couche 3 a été partiellement éliminée de la surface de la région active, de façon à former dans les zones correspondant au point mémoire T2 une fenêtre W dont le contour est illustré, en vue de dessus, en traits pointillés en figure 2A, et dont la largeur Ww et la longueur Wl apparaissent respectivement aux figures 2B et 2C. La fenêtre W s'étend sur toute la largeur de la région active et jusqu'à et au-dessus des zones d'isolement de champ 2. Une couche isolante 4 a été formée par oxydation thermique de la surface découverte du substrat 1 au fond de la fenêtre W. La couche 4 constitue une zone d'oxyde tunnel de l'isolant de la grille flottante FG du point pire T2.

Une couche conductrice 5 recouvre les couches isolantes 3 et 4 et une partie des zones 2. Typiquement en silicium polycristallin d'une épaisseur de 150 nm, la couche 5 est gravée pour constituer la grille flottante FG du point mémoire T2 et au moins une partie de la grille G1 du transistor.

Une couche isolante 6 recouvre la couche 5. Typiquement un multicouche d'oxyde de silicium - nitrure de silicium (Si₃N₄) - oxyde de silicium (ONO) d'une épaisseur comprise entre 210 et 230 nm, la couche 6 est destinée à constituer l'isolant de la grille de commande CG du point mémoire T2.

Enfin, une couche conductrice 7 recouvre la couche 6. Typiquement en silicium polycristallin dopé in situ, d'une épaisseur comprise entre 400 et 500 nm, généralement de 450 nm, la couche 7 est essentiellement destinée à constituer la grille de commande CG. Pour former la grille Gl, les portions correspondantes des couches 5 et 7 sont alors reliées électriquement.

Un inconvénient de la structure obtenue est la fragilité de l'oxyde tunnel au niveau des régions frontières OP1, OP2 entre la région active et les zones 2 (figures 2A et 2C). En effet, dans ces régions frontières, la croissance de l'oxyde tunnel 4 sera en pratique irrégulière, et présentera une épaisseur moindre. Ceci provoque des risques d'apparition de courants de fuite du fait d'un "perçage" local de l'isolant. Il peut même apparaître un court-circuit entre la grille flottante FG et le substrat 1 sous-jacent.

Un autre inconvénient d'un tel procédé de formation est l'irrégularité de la longueur Wl de l'isolant tunnel. En effet, si la largeur Ww de l'isolant tunnel est définie par le masque de gravure de la couche 3 (ouverture de la fenêtre W), sa longueur Wl est définie par la largeur de la région active entre les zones 2. En pratique, les extrémités en "bec d'oiseau" des zones 2 sont irrégulières. La longueur et donc la surface de l'isolant 4 est alors mal définie et peut varier d'une cellule mémoire à l'autre. Cette surface peut être insuffisante ou excessive et conduire à des dysfonctionnements du dispositif.

Un objet de la présente invention est par conséquent de proposer un nouveau procédé de formation d'une nouvelle structure de cellule mémoire ne présentant pas les défauts susmentionnés.

Pour atteindre ces objets, la présente invention prévoit un procédé de formation d'un point mémoire comportant une grille de commande et une grille flottante au-dessus d'un isolant comportant une zone suffisamment mince pour permettre un effet tunnel entre un substrat semiconducteur sous-jacent et la grille flottante, comprenant les étapes suivantes :
délimiter à la surface du substrat une région active par des zones d'isolement de champ ;
former une première couche isolante ;
ouvrir une fenêtre dans la première couche isolante de façon à découvrir partiellement toute la largeur de la région active et une partie des zones d'isolement ;
former une deuxième couche isolante très mince par oxydation thermique ;
déposer un premier matériau conducteur ;
former une troisième couche isolante ; et
déposer un deuxième matériau conducteur,
et comprenant en outre l'étape consistant à graver le deuxième matériau conducteur, la troisième couche isolante, le premier matériau conducteur et les deuxième et première couches isolantes selon un même contour de façon à découvrir la région active et les zones d'isolement au voisinage des régions frontières entre la région active et les zones d'isolement.

Selon un mode de réalisation de la présente invention, l'étape de gravure du deuxième matériau conducteur, de la troisième couche isolante, du premier matériau conducteur et des deuxième et première couches isolantes permet de définir la structure de grille d'un transistor de lecture d'une cellule mémoire de type EEPROM comportant ledit point mémoire.

Selon un mode de réalisation de la présente invention, la fenêtre a une forme rectangulaire.

Selon un mode de réalisation de la présente invention, la fenêtre a des dimensions de 0,7^{∗}1,2 µm.

Selon un mode de réalisation de la présente invention, la première couche isolante est une couche d'oxyde de silicium d'une épaisseur comprise entre 20 et 30 nm.

Selon un mode de réalisation de la présente invention, l'oxyde thermique a une épaisseur comprise entre 5 et 10 nm.

Selon un mode de réalisation de la présente invention, le premier matériau conducteur est une couche de silicium polycristallin d'une épaisseur de 150 nm.

Selon un mode de réalisation de la présente invention, le deuxième matériau conducteur est une couche de silicium polycristallin d'une épaisseur comprise entre 400 et 500 nm.

Selon un mode de réalisation de la présente invention, après le dépôt du deuxième matériau conducteur, on procède à une étape de siliciuration de la surface du deuxième matériau conducteur.

Selon un mode de réalisation de la présente invention, le deuxième matériau conducteur est un multicouche de silicium polycristallin et de siliciure de tungstène.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente le schéma équivalent d'une cellule mémoire de type EEPROM ;
les figures 2A, 2B et 2C illustrent la réalisation d'une cellule du type représenté en figure 1 selon un procédé classique ; et
les figures 3A, 3B et 3C illustrent la structure d'une cellule du type représenté en figure 1 réalisée à l'aide d'un procédé selon la présente invention.

Par souci de clarté, les mêmes éléments ont été désignés par les mêmes références aux différentes figures et, de plus, comme cela est habituel dans la représentation des circuits intégrés, les figures 2A à 3C ne sont pas tracées à l'échelle.

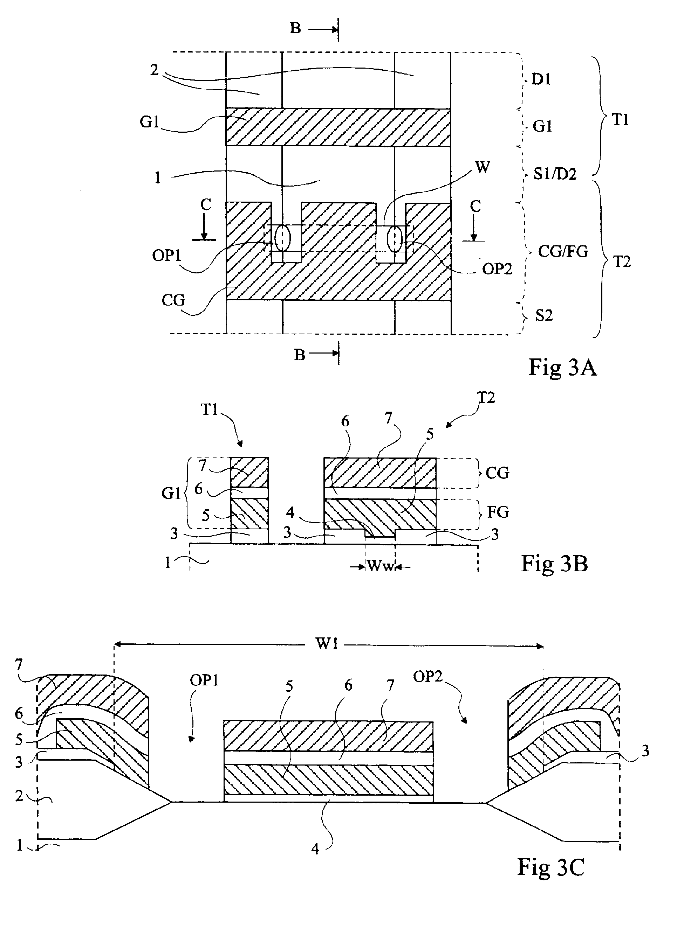

Les figures 3A, 3B et 3C illustrent le résultat d'un procédé selon l'invention. Plus particulièrement, les figures 3A, 3B et 3C représentent une cellule mémoire selon des vues respectives de dessus et en coupe selon un premier axe B-B et un second axe C-C.

Pour plus de clarté, la cellule mémoire illustrée aux figures 3A, 3B et 3C est du type décrit précédemment en relation avec la figure 1. En outre, les figures 3A, 3B et 3C illustrent une telle cellule à une étape de sa fabrication similaire à celle des figures 2A, 2B et 2C, les axes de coupe respectifs B-B et C-C des figures respectives 2B, 3B et 2C, 3C étant les mêmes.

Le procédé selon la présente invention commence par la définition d'une région active à la surface d'un substrat 1 à l'aide de zones d'isolement de champ 2.

On forme ensuite un premier isolant de grille 3. L'isolant 3 est similaire à un isolant classique. Il s'agit par exemple d'une couche d'oxyde de silicium déposée par voie chimique en phase vapeur sur une épaisseur comprise entre 20 et 30 nm.

Dans les zones correspondant au point mémoire T2, l'isolant 3 est ensuite gravé de façon à former une fenêtre W. Comme précédemment, les dimensions de la fenêtre W sont choisies de façon qu'elle s'étend sur toute la largeur de la région active, et en partie au-dessus des zones 2. La fenêtre W est par exemple rectangulaire et sa largeur Ww (figure 3B) et sa longueur Wl (figure 3C) sont, par exemple, d'environ 0,7 et 1,2 µm, respectivement.

On procède alors à une oxydation thermique. Les conditions de l'oxydation sont telles que la couche 4 ainsi formée est très mince, d'une épaisseur comprise entre 5 et 10 nm. La couche 4 est destinée à constituer l'oxyde tunnel de la grille flottante FG du point mémoire T2.

On dépose ensuite successivement une première couche conductrice 5, un deuxième isolant de grille 6 et une deuxième couche conductrice 7, respectivement. Du côté du point mémoire T2, ces couches sont destinées à constituer respectivement la grille flottante FG, un isolant inter-grille et la grille de commande CG. De préférence, on procède à une gravure de la périphérie de la première couche conductrice 5 avant le dépôt des couches suivantes.

Enfin, pour obtenir la structure illustrée aux figures 3A, 3B et 3C, les grilles des éléments T1 et T2 sont individualisées par gravure des couches conductrices et isolantes 3, 4, 5, 6 et 7. Selon l'invention, ce dernier masque de gravure est modifié. Comme pour une cellule classique, les structures de grille des éléments T1 et T2 sont individualisées et le substrat sous-jacent 1 est mis à nu entre celles-ci, comme l'illustrent les figures 3A et 3B. Toutefois, dans la zone du point mémoire T2, les régions frontières OP1 et OP2 sont exclues de la structure de grille, comme cela ressort de la comparaison des figures 2A et 3A et des figures 2C et 3C. En d'autres termes, selon l'invention, on découvre la région active et les zones d'isolement 2 au voisinage des régions frontières OP1 et OP2.

On notera qu'il est préférable de modifier le seul masque de gravure d'individualisation finale. On pourrait en effet modifier également le masque de gravure de la première couche conductrice 5 (avant dépôt de la couche isolante 6). Toutefois, lors de la gravure finale d'individualisation des structures de grille (mise à nu du substrat 1 entre les structures, illustrée aux figures 3A et 3B), le substrat subirait alors désavantageusement une surgravure importante dans les zones de drain/source des éléments T1 et T2.

Le procédé se poursuit ensuite de façon classique, par exemple par la formation d'espaceurs (non représentés) sur les côtés des structures de grille et/ou le dopage des différentes régions de drain et de source D1, D2 et S1, S2 des éléments T1 et T2.

La couche 7 peut être constituée soit de silicium polycristallin dopé in situ, déposé sur une épaisseur de 450 nm, soit d'un multicouche de 150 nm de silicium polycristallin dopé in situ et de 250 nm de siliciure de tungstène (Wsi₂). Dans le cas d'une monocouche de silicium polycristallin, elle peut être siliciurée avant la gravure finale. De même, bien qu'on ait choisi de conserver l'empilement des trois couches 5, 6 et 7 pour former la grille G1 du transistor de lecture T1, il serait possible d'éliminer localement, avant le dépôt de la couche conductrice 7 les couches 5 et 6, l'électrode G1 étant alors constituée de la seule couche 7. Il serait également possible de graver les couches isolante 6 et conductrice 7, l'électrode G1 étant alors constituée de la seule couche 5, ou encore d'éliminer localement l'isolant 6 avant le dépôt de la couche 7, assurant une électrode G1 constituée par la mise en contact direct des couches 5 et 7.

Il est également possible d'effectuer des dopages préalables de la région active, par exemple, avant le dépôt de la première couche isolante 3, et/ou après l'ouverture de la fenêtre W.

Un avantage de la présente invention est que la longueur de l'oxyde tunnel est parfaitement définie par le masque de gravure des différentes couches. Sa largeur étant définie par le masque de formation de la fenêtre W, sa surface est donc fixée.

Du fait que les régions frontières OP1 et OP2 sont exclues de la zone tunnel, tous les inconvénients liés à ces régions frontières dans des structures classiques sont avantageusement éliminés.

Bien entendu, la présente invention est susceptible de diverses variantes et modifications qui apparaîtront à l'homme de l'art. En particulier, on a décrit et illustré précédemment les principes de l'invention appliqués à la formation simultanée d'un transistor de lecture et d'un point mémoire à grille de commande et à grille flottante à isolant tunnel. L'homme de l'art saura adapter les matériaux et dessins de masque décrits à une filière de fabrication spécifique et sélectionner les épaisseurs et niveaux de dopage des diverses couches isolantes et conductrices en fonction des performances recherchées.

## Revendications

1. Procédé de formation d'un point mémoire (T2) comportant une grille de commande (CG) et une grille flottante (FG) au-dessus d'un isolant comportant une zone suffisamment mince pour permettre un effet tunnel entre un substrat semiconducteur (1) sous-jacent et la grille flottante, comprenant les étapes suivantes :
délimiter à la surface du substrat une région active par des zones d'isolement de champ (2) ;
former une première couche isolante (3) ;
ouvrir une fenêtre (W) dans la première couche isolante de façon à découvrir partiellement toute la largeur de la région active et une partie des zones d'isolement ;
former une deuxième couche isolante très mince (4) par oxydation thermique ;
déposer un premier matériau conducteur (5) ;
former une troisième couche isolante (6) ; et
déposer un deuxième matériau conducteur (7),
caractérisé en ce qu'il comprend en outre l'étape consistant à graver le deuxième matériau conducteur, la troisième couche isolante, le premier matériau conducteur et les deuxième et première couches isolantes selon un même contour de façon à découvrir la région active et les zones d'isolement au voisinage des régions frontières (OP1, OP2) entre la région active et les zones d'isolement.

2. Procédé selon la revendication 1, caractérisé en ce que l'étape de gravure du deuxième matériau conducteur (7), de la troisième couche isolante (6), du premier matériau conducteur (5) et des deuxième et première couches isolantes (4, 3) permet de définir la structure de grille (G1) d'un transistor (T1) de lecture d'une cellule mémoire de type EEPROM comportant ledit point mémoire (T2).

3. Procédé selon l'une quelconque des revendications 1 ou 2, caractérisé en ce que la fenêtre (W) a une forme rectangulaire.

4. Procédé selon la revendication 3, caractérisé en ce que la fenêtre (W) a des dimensions (Ww, Wl) de 0,7^{∗}1,2 µm.

5. Procédé selon l'une quelconque des revendications 1 à 4, caractérisé en ce que la première couche isolante (3) est une couche d'oxyde de silicium d'une épaisseur comprise entre 20 et 30 nm.

6. Procédé selon l'une quelconque des revendications 1 à 5, caractérisé en ce que l'oxyde thermique (4) a une épaisseur comprise entre 5 et 10 nm.

7. Procédé selon l'une quelconque des revendications 1 à 6, caractérisé en ce que le premier matériau conducteur (5) est une couche de silicium polycristallin d'une épaisseur de 150 nm.

8. Procédé selon l'une quelconque des revendications 1 à 7, caractérisé en ce que le deuxième matériau conducteur (7) est une couche de silicium polycristallin d'une épaisseur comprise entre 400 et 500 nm.

9. Procédé selon la revendication 8, caractérisé en ce qu'il comprend, après le dépôt du deuxième matériau conducteur (7), une étape de siliciuration de la surface du deuxième matériau conducteur.

10. Procédé selon l'une quelconque des revendications 1 à 7, caractérisé en ce que le deuxième matériau conducteur (7) est un multicouche de silicium polycristallin et de siliciure de tungstène.
